# EUROPÄISCHE PATENTSCHRIFT

(11) **EP 4 112 949 B1**
(45) Veröffentlichungstag und Bekanntmachung des Hinweises auf die Patenterteilung: **25.12.2024**
(21) Anmeldenummer: 22177196.7
(22) Anmeldetag: 03.06.2022
(51) Int. Cl.: F16B 19/00, F16B 21/08

(54) **ELEKTRONIKMODUL UND HERSTELLVERFAHREN**
ELECTRONIC MODULE AND MANUFACTURING METHOD
MODULE ÉLECTRONIQUE ET PROCÉDÉ DE FABRICATION

(30) Priorität: 01.07.2021 DE 102021116940
(43) Veröffentlichungstag der Anmeldung: 04.01.2023
(73) Patentinhaber: Turck Holding GmbH, 58553 Halver (DE)
(72) Erfinder: Löwen, Nikolaj, 42287 Wuppertal (DE)
(74) Vertreter: DTS Patent- und Rechtsanwälte PartmbB

(56) Entgegenhaltungen:
- WO-A1-2012/079837
- BE-A- 824 335
- DE-U1- 9 110 871
- DE-U1- 9 214 673

## Beschreibung

Die vorliegende Erfindung betrifft ein Elektronikmodul nach dem Oberbegriff des Anspruchs 1 und ein Herstellverfahren nach dem Oberbegriff des Anspruchs 9.

Im Stand der Technik sind zweiseitige Befestigungsmittel zur steckenden Verbindung von zwei Bauteilen bekannt. So offenbart bspw. die DE 740 1200 U bzw. die BE 824 335 einen doppelseitigen Dübel, der zur Verbindung einer Türzarge in einem Rahmenelement geeignet ist. Weiterhin sind im Stand der Technik umseitig geschlossene elektronische Bauteile oder Module bekannt, bei denen eine Leiterplatte im Inneren befestigt wird. Beispielsweise ist aus der US 5,535,100 B bekannt, die Leiterplatte (Platine) mit einem Distanzhalter an einer Gehäuseunterseite zu befestigen, indem Distanz- und Befestigungselemente aus Kunststoff mit Schnapphaken in eine Gehäusewand eingesetzt und befestigt werden. Die Leiterplatte wird aufgelegt und verklemmt. Aus der US 10,928,441 B2 ist eine Befestigung für eine Platine mittels Schrauben bekannt, an welchen die Platine schwebend gelagert wird, indem über mehrere Muttern entlang der Schrauben eine Höhenlage eingestellt wird. Weitere Verbindungen für elektronische Module aus zwei Gehäusehälften sind aus der DE 92 14 673 U1 und der DE 91 10 871 U1 bekannt.

An diesen Ausführungsformen ist nachteilig, dass sie viele Befestigungskomponenten und einen hohen Fertigungsaufwand erfordern. Weiterhin wird auf der Leiterplatte für die Befestigung eine große Fläche verbraucht, die funktional für die eigentlichen elektrischen oder datenleitenden Prozesse nicht mehr nutzbar ist.

Es ist die Aufgabe der vorliegenden Erfindung eine verbesserte Befestigung für Leiterplatten in einem Gehäuse eines Elektronikmoduls vorzuschlagen, die die vorgenannten Nachteile umgeht.

Diese Aufgabe wird erfindungsgemäß gelöst durch ein Elektronikmodul nach den Merkmalen des Anspruchs 1 und ein Herstellverfahren nach den Merkmalen des Anspruchs 9. Vorteilhafte Ausgestaltungen sind in den jeweiligen, zugehörigen Unteransprüchen angegeben.

Danach wird die Aufgabe gelöst durch einen Rastbolzen zum Verbinden von Bauteilen eines Elektronikmoduls, welcher zur kraft- und/oder formschlüssigen Einführung in ein mindestens teilweise umschließendes Aufnahmeelement dient, umfassend mindestens einen Auflageabschnitt und einen ersten Bolzenabschnitt mit einem Kopfende und einem verbindenden Halsabschnitt, wobei mindestens ein ein- oder mehrteiliger Schneid- und/oder Reibkranz im Bereich des Kopfendes und/oder des Halsabschnittes angeordnet ist.

Der Kern der Erfindung besteht darin, dass ein zweiter Bolzenabschnitt an der Rückseite des Auflageabschnitts angeordnet ist, wobei der zweite Bolzenabschnitt ebenfalls ein Kopfende und einen verbindenden Halsabschnitt aufweist, und wobei mindestens ein ein- oder mehrteiliger Schneid- und/oder Reibkranz im Bereich des Kopfendes und/oder des Halsabschnittes angeordnet ist. Hierbei sind Schneid- und/oder Reibkranz nicht limitierend zu verstehen und meint alle Oberflächengeometrien oder -beschaffenheiten des Rastbolzens oder Abschnitte hiervon, die zu einem Einschneiden und/oder Eindrücken in eine gegenüberliegende und/oder umgreifende Oberfläche eines Aufnahmeelements führen.

Damit wird der große Vorteil erreicht, dass durch ein einfaches Ineinanderstecken oder -pressen, zum einen die Leiterplatte durch den auskragenden Auflageabschnitt des Rastbolzens auf den Aufnahmeelementen des Gehäuseunterteils zentriert und dauerhaft aufgepresst werden und zum anderen das Gehäuseoberteil ebenfalls einfach aufgepresst werden kann und zwar gleichzeitig in nur einem Verfahrensschritt auf alle Rastbolzen.

Der Rastbolzen kann grundsätzlich symmetrisch hinsichtlich der beiden Bolzenabschnitte ausgebildet sein, wobei vorteilhafterweise der zweite Bolzenabschnitt kürzer als der erste Bolzenabschnitt ausgeführt ist, wobei in Abhängigkeit von der Dicke der Leiterplatte die Länge des zweiten Bolzenabschnitts das 0,25fach bis 0,75fache des ersten Bolzenabschnitts beträgt.

Bei einer verbesserten Ausführungsform ist mindestens eines der Kopfenden als pilzkopf- oder kappenartige Erweiterung ausgeführt, wobei die umlaufende Unterkante als Schneidkranz ausgeführt ist. Alternativ oder zusätzlich kann die äußere Oberfläche des pilzkopf- oder kappenartigen Kopfendes, insbesondere im Randbereich gerändelte oder mit Widerhaken ausgebildete Flächen aufweisen.

Die Oberflächen eines Schneid- und/oder Reibkranzes kann vielfältig ausgebildet sein, wobei mögliche Ausführungen beispielsweise Widerhaken, Rändelungen oder spitze Rillen im vollen oder abschnittsweisen Umfang sind. Hierbei ist allen schneidenden und/oder reibenden Oberflächengeometrien gemein, dass diese leicht in Montagerichtung einzuführen sind und sich durch die Verkrallung an der Wand oder in Wandabschnitten eines Aufnahmeelementes fest einprägen, so dass diese nicht mehr zerstörungsfrei herausgezogen oder -gedreht werden können.

Eine weiter verbesserte Ausführungsform sieht vor, dass an mindestens einem Halsabschnitt ein ein- oder mehrteiliger Schneid- und/oder Reibkranz angeordnet ist, wobei idealerweise mehrere Schneid- und/oder Reibkränze vorgesehen sind. Für die Oberflächengeometrien gilt das vorstehend genannte in analoger Weise.

Der Rastbolzen ist vorteilhafterweise aus einem Metall, insbesondere einem nicht-rostenden Metall oder einem Kunststoff ist, insbesondere aus PVC (Polyvinylchlorid), PP (Polypropylen), POM (Polyoxymethylen) oder PET (Polyethylenterephthalat) hergestellt.

Das erfindungsgemäße Elektronikmodul, umfasst ein Gehäuseunterteil, eine Leiterplatte (Platine) und ein Gehäuseoberteil, wobei die Leiterplatte mindestens eine Durchführungsöffnung zur Befestigung mit einem Befestigungsmittel aufweist, welches mit einem ersten Ende durch die Durchführungsöffnung in ein fluchtend angeordnetes Aufnahmeelement des Gehäuseunterteils kraft- und/oder formschlüssig eingebracht und befestigt ist.

Der Kern des erfinderischen Elektromoduls besteht darin, dass am Gehäuseoberteil ein zum Aufnahmeelement des Gehäuseunterteils fluchtend angeordnetes Aufnahmeelement vorgesehen ist. Das andere Ende des Befestigungsmittels wird in analoger Weise kraft- und/oder formschlüssig in das Aufnahmeelement des Gehäuseoberteils eingebracht und befestigt, insbesondere form- und/oder kraftschlüssig eingepresst.

Unter den Durchführungsöffnungen der Leiterplatte sind einerseits umlaufende Aussparungen oder Öffnungen zu verstehen, aber auch Aussparungen im Rand- oder Kantenbereich, die nach außen offen sind, also nicht umlaufend geschlossen. Diese sind in der Geometrie nicht festgelegt und können beispielsweise als Oval- oder Kreisausschnitt ausgebildet sein.

Eine Verbesserung besteht darin, dass das Gehäuseoberteil und -unterteil einen Rand aufweisen, wobei die Ränder mindestens abschnittsweise miteinander durch eine Dichtauflage abgedichtet oder durch ein Klebemittel verklebt sind. Vorteilhafterweise sind die Ränder auf der gesamten Länge miteinander abgedichtet und/oder verklebt.

Bei einer weiteren, verbesserten Ausführungsform ist das Befestigungsmittel als Rastbolzen nach einem der vorgenannte Ausführungsvarianten ausgebildet.

Eine weitere Verbesserung besteht darin, dass die Anbringung mindestens eines der Aufnahmeelemente derart ist, dass zwischen einer Gehäusewand und einem der Aufnahmeelemente ein stegartiges Tragelement angeordnet ist. Bei einer alternativen Ausführungsform ist mindestens ein Aufnahmeelement säulen- oder hülsenartig lotrecht zur Leiterpatte auf oder an einer Gehäusewand angebracht oder monolithisch aus der Gehäusewand ausgeformt.

Hierbei ist das Gehäuseunterteil dadurch definiert, dass es das Gehäuseteil ist, an oder auf welchem die Leiterplatte in einem ersten Arbeitsschritt befestigt wird. Das Gehäuseoberteil wird in analoger Weise dadurch definiert, dass dieses das andere Gehäuseteil ist, welches nicht das Gehäuseunterteil darstellt. Das Elektronikmodul ist hierdurch in der Einbaulage nicht eingeschränkt, so dass auch das Gehäuseunterteil in der finalen Einbaulage hinsichtlich der Schwerkraft oberhalb des Gehäuseoberteils angeordnet sein kann.

Bei dem erfindungsgemäßen Herstellverfahren für ein Elektronikmodul wird eine mindestens eine Durchführungsöffnung aufweisende Leiterplatte in einem Gehäuseunterteil mit Befestigungsmitteln an oder in mindestens einem Aufnahmeelement angebracht und anschließend wird ein Gehäuseoberteil befestigt, wobei die folgenden Schritte vorgenommen werden:
a) Bereitstellung des Gehäuseunterteils,
b) Auflage der Leiterplatte auf ein oder mehrere Aufnahmeelemente des Gehäuseunterteils,
c) Durchführen eines oder mehrerer Befestigungsmittel durch die Durchführungsöffnungen und einpressen in das mindestens eine Aufnahmeelement, wobei das Befestigungsmittel als Rastbolzen nach einem vorgenannten Ausführungsvarianten ausgebildet ist und
d) Einpressen des Kopfendes des zweiten Bolzenabschnitts in mindestens ein Aufnahmeelement des Gehäuseoberteils.

Hierbei wird insbesondere ein Elektronikmodul nach einem der vorstehend genannten Ausführungsformen hergestellt.

Eine Verbesserung des Herstellverfahrens besteht darin, dass vor Schritt d), dem Einpressen des Gehäuseoberteils, ein Dicht- und/oder Klebematerial mindestens abschnittsweise auf einen Gehäuserand aufgebracht wird.

Der besondere Vorteil besteht darin, dass ein unmittelbarer kraftschlüssiger Verbund zwischen Gehäuseoberteil und -unterteil erfolgt, auch bei einem Auftrag eines Klebers oder Klebemittel. Hierzu sind keine weiteren Befestigungsmittel erforderlich, auch keine Halte- und Befestigungsmittel, die für die Zeit der Aushärtung und Trocknung eines Klebemittels zeitweise die erforderliche Anpressung sicher stellen. Das Elektronikmodul kann unmittelbar weitertransportiert und bewegt werden, auch während ein Kleber trocknet und aushärtet.

Vorteilhafterweise wird mindestens jeweils ein Schneid- und/oder Reibkranz in jedem Aufnahmeelement des Gehäuseober- und -unterteil form- und kraftschlüssig eingepresst.

Weitere Einzelheiten und Vorteile der Erfindung sollen nun anhand der in den Zeichnungen dargestellten Ausführungsbeispielen näher erläutert werden.

Es zeigen:
Fig. 1a), b) eine erste Ausführungsform des Rastbolzen,
Fig. 2a), b) zwei weitere Ausführungsformen des Rastbolzens und eine schematische, alternative Ausführungsform und
Fig. 3a), b) und c) drei Schritte des Herstellungsverfahrens eines Elektronikmoduls.

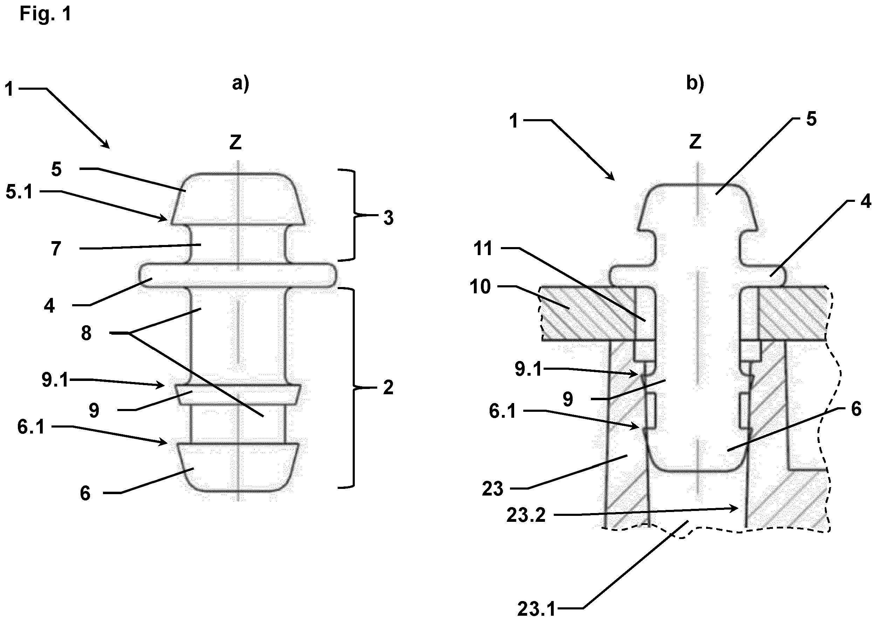

In der Figur 1a) ist der Rastbolzen 1 als Seitenansicht gezeigt, der einen unteren ersten Bolzenabschnitt 2, einen oberen zweiten Bolzenabschnitt 3 und einen dazwischen angeordneten Auflageabschnitt 4 aufweist, der einen größeren Durchmesser als die beiden Bolzenabschnitte 2, 3 aufweist. Der Rastbolzen 1, gemäß den Figuren 1a) und Figur 1b) ist zur Hochachse Z rotationssymmetrisch ausgebildet, wobei die Erfindung hierauf nicht eingeschränkt ist. Beide Bolzenabschnitte 2, 3 weisen jeweils ein Kopfende 5, 6 auf, das jeweils mit einem Halsabschnitt 7, 8 mit dem Auflageabschnitt 4 verbunden ist. Beide Kopfenden 5, 6 sind als pilzkopf- oder kappenartige Erweiterungen der jeweiligen Halsabschnitte 7, 8 ausgeformt und weisen an ihrem unteren, dem Auflageabschnitt 4 zugewandten Ende eine Schneidkante 5.1, 6.1 auf. An dem ersten Bolzenabschnitt 2, der die doppelte Länge des zweiten Bolzenabschnitts 3 aufweist, ist ein Schneid- und/oder Reibkranz 9 angeordnet, dessen umlaufende Oberfläche zum freien Ende hin in Richtung der Achse Z geneigt ist, um die Einführung in ein Aufnahmeelement 23 zu erleichtern. An seinem unteren, dem Auflageelement 4 zugewandten Seite weist dieser eine Schneidkante 9.1 auf.

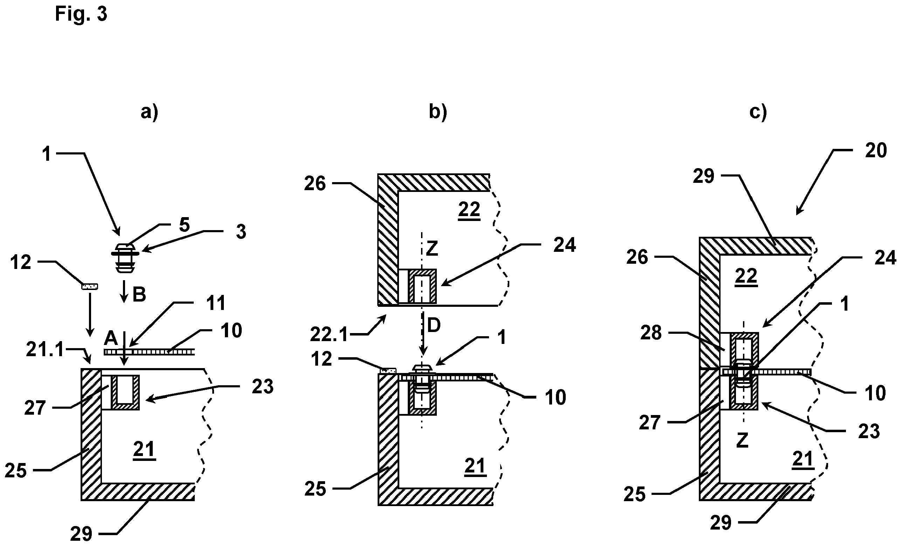

Figur 1b) zeigt den Rastbolzen 1 gemäß Figur 1a) in der Einbaulage. Der erste Bolzenabschnitt 2 des Rastbolzens 1 ist durch die Durchführungsöffnung 11 der Leiterplatte 10 und in die Öffnung 23.1 des Aufnahmeelementes 3 geführt. Der Auflageabschnitt 4 presst die Leiterplatte 10 auf die Oberkante des Aufnahmeelements 23 des nicht weiter gezeigten Gehäuseunterteils 21 (Fig. 3), während die Schneidkante 6.1 des Kopfendes 6 und die Schneidkante 9.1 des Schneid- und Reibkranzes 9 in die Innenwand 23.2 des Aufnahmeelements 23 schneiden und somit kraft- und formschlüssig festgelegt sind und nur noch zerstörend gelöst werden können. Das obere Kopfende 5 des zweiten Bolzenabschnitts 3 ist noch frei, so dass hierauf ein Gehäuseoberteil 22, bzw. dessen Aufnahmeelemente 24 angebracht und befestigt werden können, wie in Figur 3 gezeigt.

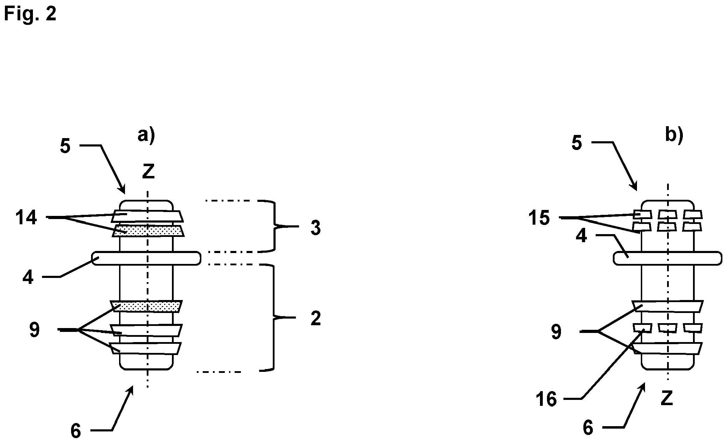

In den Figuren 2a) und 2b) sind weitere Ausführungsformen des Rastbolzens 1 gezeigt, denen gemeinsam ist, dass kein pilz- oder kappenartiger Kopf ausgebildet ist, sondern eine Mehrzahl von Schneid- und/oder Reibkränzen 9, 14, 15, 16 vorgesehen sind. In dem Ausführungsbeispiel nach Figur 2a) sind am unteren, ersten Bolzenabschnitt 2 drei umlaufende, parallele Schneid- und/oder Reibkränze 9 und am oberen, zweiten Bolzenabschnitt 3, zwei umlaufende, parallele Schneid- und/oder Reibkränze 14 angeordnet. Von diesen ist der jeweils tiefste mit einer Oberflächenrändelung versehen, was durch die Punktierung der Fläche angedeutet wurde. Wie in der Figur 2b) beispielhaft dargestellt, können die Schneid- und/oder Reibkränze auch unterbrochen oder zahn- oder krallenartig ausgebildet sein, wie für die drei der Schneid- und/oder Reibkränze 15, 16 dargestellt. Diese bestehen aus einer Mehrzahl umlaufend angeordneter Zahl- oder Krallenelemente. Bei nicht dargestellten Ausführungsvarianten sind die beiden Bolzenabschnitte 2, 3 identisch ausgeformt, so dass der Rastbolzen 1 insgesamt symmetrisch ausgeformt ist.

Der Rastbolzen 1 übernimmt somit zwei Funktionen, indem der einerseits die Leiterplatte 11 (Platine) hält und weiterhin auch das Gehäuseoberteil 22 fixiert. Anders ausgedrückt, er fungiert als eine Art Sandwichverbinder, der die beiden Gehäusehälften aus Gehäuseoberteil 22 und Gehäuseunterteil 21 verbindet und im vorherigen Montageschritt noch zusätzlich auch die Leiterplatte 11 (Platine) dauerhaft (unlösbar) arretiert.

Der Rastbolzen 1 übernimmt somit im Montageschritt die Fixierung und Positionierung zwischen Gehäuseunterteil 21 und Leiterplatte 11, währen das Gehäuseoberteil 22 herangeführt und unter Krafteinwirkung aufgepresst wird. Weiter übernimmt der Rastbolzen 1 die dauerhafte Verbindung dieser Teile, weil er in dem fertigen Modulgehäuse 20 verbleibt.

In der Figur 3a) werden die ersten Schritte des Herstellverfahrens dargestellt. Das Gehäuseunterteil 21 wird bereitgestellt und die Leiterplatte 10 von oben in Richtung des Pfeils A fluchtend mit den Öffnungen 11 auf den Aufnahmeelementen 23 aufgelegt, wovon nur eines dargestellt ist. Das Aufnahmeelemente 23 ist an einem stegartigen Tragelemente 27 an der Gehäusewand 25 angebracht. Anschließend wird in Richtung B der Rastbolzen 1 herangeführt und eingepresst, so dass die Leiterplatte 10 auf dem Aufnahmeelement 23 fixiert ist. Zeitgleich mit vorgenannten Schritten oder nachlaufend wird in dem zeigten Beispiel ein flüssiges Dicht- und Klebemittel 12 auf den Gehäuserand 21.1 des Gehäuseunterteils 21 aufgetragen. In einer nicht gezeigten Ausführungsform kann der Gehäuserand bzw. die Gehäusewand auch eine Nut- und Federform aufweisen, so dass ein Dicht- und Klebemittel 12 beispielsweise in die Nut eingegossen wird. Alternativ, in einer nicht darstellten Herstellungsvariante, wird das Klebemittel auf dem Gehäuseoberteil 22 aufgetragen.

Nach Abschluss der Schritte gem. der Figur 3a) wird, wie in Figur 3b) dargestellt, das Gehäuseoberteil 22 von oben in Richtung D herangeführt, wobei die Richtung D der Achsrichtung Z des eingefügten Rastbolzens 1 entspricht. Das Gehäuseoberteil 22 wird auf alle Kopfteile 5 der zweiten Bolzenabschnitte 3 aufgepresst, wobei die angeschrägte oder runde Kopfform eine automatische Zentrierung des gesamten Gehäuseoberteils 22 sowie dessen Aufnahmeelemente 24 ermöglicht. Figur 3c) zeigt schließlich das verschlossene Elektronikmodul 20, bei dem die beiden Aufnahmeelemente 23, 24, welche über stegartige Tragelemente 27, 28 an den jeweiligen Gehäusewänden 25, 26 durch die eingepressten Rastbolzen 1 die beiden Gehäuseteile dichten aufeinanderpressen. Parallel und ohne zusätzliche Befestigungsmittel, wird die Leiterplatte 10 gehalten und zentriert.

Bei einer nicht gezeigten Ausführungsvariante sind die Aufnahmeelemente 23, 24 alleinig oder zusätzlich an der Gehäusedecke 29 angebracht oder diese ist abschnittsweise als Aufnahmeelemente 23, 24 ausgeformt. Die Aufnahmeelemente 23, 24 können insbesondere ein- oder mehrteilige Hülsen sein.

### Bezugszeichenliste

- 1: Rastbolzen
- 2: Bolzenabschnitt, erster
- 3: Bolzenabschnitt, zweiter
- 4: Auflageabschnitt
- 5: Kopfende, zweites
- 5.1: Schneidkranz
- 6: Kopfende, erstes
- 6.1: Schneidkante
- 7: Halsabschnitt, erster
- 8: Halsabschnitt, zweiter
- 9: Schneid- und/oder ring
- 9.1: Schneidkante
- 10: Leiterplatte
- 11: Durchführungsöffnung
- 12: Dicht- oder Klebematerial

- 14: Schneid- und Reibkranz
- 15: Schneid- und Reibkranz

- 20: Modulgehäuse
- 21: Gehäuseunterteil
- 21.1: Gehäuserand
- 22: Gehäuseoberteil
- 22.1: Gehäuserand
- 23: Aufnahmeelement
- 23.1: Öffnung
- 23.2: Innenwand
- 24: Aufnahmeelement
- 25: Gehäusewand
- 26: Gehäusewand
- 27: Tragelement
- 28: Tragelement

- A, B, D: Richtungen

- Z: Achse, Symmetrieachse

## Patentansprüche

1. Elektronikmodul (20), umfassend ein Gehäuseunterteil (21), eine Leiterplatte (10), ein Befestigungsmittel und ein Gehäuseoberteil (22), wobei die Leiterplatte (10) mindestens eine Durchführungsöffnung (11) zur Befestigung mit dem Befestigungsmittel aufweist, welches mit einem ersten Ende durch die Durchführungsöffnung (11) in ein fluchtend angeordnetes Aufnahmeelement (23) des Gehäuseunterteils (21) kraft- und/oder formschlüssig eingebracht und befestigt ist, wobei am Gehäuseoberteil (22) ein zum Aufnahmeelement (23) des Gehäuseunterteils (21) fluchtend angeordnetes Aufnahmeelement (24) vorgesehen ist, wobei das andere Ende des Befestigungsmittels kraft- und/oder formschlüssig in das mindestens eine Aufnahmeelement (23) des Gehäuseoberteils (22) eingebracht und befestigt ist, wobei das Befestigungsmittel als Rastbolzen (1) ausgeführt ist, umfassend mindestens einen auskragenden Auflageabschnitt (4) und einen ersten Bolzenabschnitt (2) mit einem Kopfende (6) und einem verbindenden Halsabschnitt (8), wobei mindestens ein ein- oder mehrteiliger Schneid- und/oder Reibkranz (6.1, 9.1) im Bereich des Kopfendes (6) und/oder des Halsabschnittes (8) angeordnet ist, wobei ein zweiter Bolzenabschnitt (3) an der Rückseite des auskragenden Auflageabschnitts (4) angeordnet ist, wobei der zweite Bolzenabschnitt (3) ein Kopfende (5) und einen verbindenden Halsabschnitt (7) aufweist, und wobei mindestens ein ein- oder mehrteiliger Schneid- und/oder Reibkranz (5.1) im Bereich des Kopfendes (5) und/oder des Halsabschnittes (7) angeordnet ist, und **dadurch gekennzeichnet, dass** die Leiterplatte (10) durch den auskragenden Auflageabschnitt (4) des Rastbolzens (1) auf den Aufnahmeelementen (23) des Gehäuseunterteils (21) zentriert und dauerhaft aufgepresst ist.

2. Elektronikmodul (20) nach Anspruch 1, **dadurch gekennzeichnet, dass** der zweite Bolzenabschnitt (3) des Rastbolzens (1) kürzer als der erste Bolzenabschnitt (2) ausgeführt ist, insbesondere die Länge des zweiten Bolzenabschnitts (3) das 0,25fache bis 0,75fache des ersten Bolzenabschnitts (2) beträgt.

3. Elektronikmodul (20) nach einem der Ansprüche 1 oder 2, **dadurch gekennzeichnet, dass** der Rastbolzen (1) an mindestens einem der Kopfenden (5, 6) als pilzkopf- und/oder kappenartige Erweiterung ausgeführt ist, dessen umlaufende Unterkante als Schneidkranz (5.1, 6.1) ausgeführt ist.

4. Elektronikmodul (20) nach einem der vorherigen Ansprüche, **dadurch gekennzeichnet, dass** an mindestens einem Halsabschnitt (7, 8) des Rastbolzens (1) ein ein- oder mehrteiliger Schneid- und/oder Reibkranz (9, 14, 15) angeordnet ist.

5. Elektronikmodul (20) nach einem der vorherigen Ansprüche, **dadurch gekennzeichnet, dass** der Rastbolzen (1) aus einem Metall, insbesondere einem nicht-rostenden Metall oder einem Kunststoff ist, insbesondere einen PVC, PP, PET oder POM hergestellt ist.

6. Elektronikmodul (20) nach einem der vorherigen Ansprüche, **dadurch gekennzeichnet, dass** das Gehäuseoberteil (22) und das Gehäuseunterteil (21) einen Rand (21.1, 22.1) aufweisen, wobei die Ränder (21.1, 22.1) mindestens abschnittsweise miteinander verklebt sind, insbesondere auf der gesamten Länge miteinander verklebt sind.

7. Elektronikmodul (20) nach einem der vorherigen Ansprüche, **dadurch gekennzeichnet, dass** das mindestens zwischen einer Gehäusewand (25, 26) und einem der Aufnahmeelemente (23, 24) ein stegartiges Tragelement (27, 28) angeordnet ist.

8. Elektronikmodul (20) nach einem der vorherigen Ansprüche, **dadurch gekennzeichnet, dass** mindestens ein Aufnahmeelement (23, 24) säulen- und/oder hülsenartig ausgebildet und auf einer Gehäusedecke (29) angebracht ist und/oder die Gehäusedecke (29) abschnittsweise als säulen- und/oder hülsenartiges Aufnahmeelement (23, 24) ausgebildet ist.

9. Herstellverfahren für ein Elektronikmodul (20), bei welchem eine mindestens eine Durchführungsöffnung (11) aufweisende Leiterplatte (10) in einem Gehäuseunterteil (21) mit Befestigungsmitteln an mindestens einem Aufnahmeelement (23, 24) angebracht und anschließend ein Gehäuseoberteil (22) befestigt wird, **dadurch gekennzeichnet, dass** das die folgenden Schritt vorgenommen werden:
a) Bereitstellung des Gehäuseunterteils (21)
b) Auflage der Leiterplatte (10) auf das mindestens eine Aufnahmeelemente (23) des Gehäuseunterteils (21),
c) Durchführen des mindestens einen Befestigungsmittels durch die Durchführungsöffnung (11) und einpressen in das mindestens eine Aufnahmeelement (23), wobei das Elektronikmodul (20) mit dem Befestigungsmittel als ein Rastbolzen (1) nach einem der Ansprüche 1 bis 8 ausgebildet ist und
d) Einpressen des Kopfendes (6) des zweiten Bolzenabschnitts (3) in mindestens ein Aufnahmeelement (24) des Gehäuseoberteils (22).

10. Herstellverfahren nach Anspruch 9, **dadurch gekennzeichnet, dass** vor Schritt d) ein Dicht- oder Klebematerial (12) mindestens abschnittsweise auf einen Gehäuserand (21.1, 22.1) aufgebracht und/oder -gelegt wird.

11. Herstellverfahren nach einem der Ansprüche 9 oder 10, **dadurch gekennzeichnet, dass** mindestens jeweils ein Schneid- und/oder Reibkranz (5.1, 6.1, 9, 9.1, 14, 15) in jedem Aufnahmeelement (23, 24) des Gehäuseober- und -unterteil form- und/oder kraftschlüssig eingepresst wird.

## Claims

1. Electronics module (20) comprising a housing lower part (21), a printed circuit board (10), a fastening means and a housing upper part (22), the printed circuit board (10) having at least one through-opening (11) for fastening with the fastening means, which is force-fittingly and/or form-fittingly introduced by way of a first end through the through-opening (11) into a receiving element (23), arranged in line, of the housing lower part (21) and fastened, a receiving element (24) arranged in line with the receiving element (23) of the housing lower part (21) being provided on the housing upper part (22), the other end of the fastening means being force-fittingly and/or form-fittingly introduced into the at least one receiving element (23) of the housing upper part (22) and fastened, the fastening means being in the form of a locking bolt (1) comprising at least one protruding support portion (4) and a first bolt portion (2) with a head end (6) and a connecting neck portion (8), at least one single-part or multi-part cutting and/or friction ring (6.1, 9.1) being arranged in the region of the head end (6) and/or the neck portion (8), a second bolt portion (3) being arranged on the rear side of the protruding support portion (4), the second bolt portion (3) having a head end (5) and a connecting neck portion (7), and at least one single-part or multi-part cutting and/or friction ring (5.1) being arranged in the region of the head end (5) and/or the neck portion (7), and **characterized in that** the printed circuit board (10) is centred and permanently pressed on the receiving elements (23) of the housing lower part (21) by the protruding support portion (4) of the locking bolt (1).

2. Electronics module (20) according to Claim 1, **characterized in that** the second bolt portion (3) of the locking bolt (1) is shorter than the first bolt portion (2), in particular the length of the second bolt portion (3) is 0.25 times to 0.75 times the first bolt portion (2) .

3. Electronics module (20) according to either of Claims 1 and 2, **characterized in that** the locking bolt (1) at least at one of the head ends (5, 6) is in the form of a mushroom-head-like and/or cap-like widening, the encircling lower edge of which is in the form of a cutting ring (5.1, 6.1).

4. Electronics module (20) according to one of the preceding claims, **characterized in that** a single-part or multi-part cutting and/or friction ring (9, 14, 15) is arranged on at least one neck portion (7, 8) of the locking bolt (1).

5. Electronics module (20) according to one of the preceding claims, **characterized in that** the locking bolt (1) is made of a metal, in particular a stainless metal, or a plastic, in particular a PVC, PP, PET or POM.

6. Electronics module (20) according to one of the preceding claims, **characterized in that** the housing upper part (22) and the housing lower part (21) have an edge (21.1, 22.1), the edges (21.1, 22.1) being adhesively bonded to one another at least in certain portions, in particular adhesively bonded to one another over the entire length.

7. Electronics module (20) according to one of the preceding claims, **characterized in that** a bar-like carrying element (27, 28) is arranged at least between a housing wall (25, 26) and one of the receiving elements (23, 24) .

8. Electronics module (20) according to one of the preceding claims, **characterized in that** at least one receiving element (23, 24) has a pillar-like and/or sleeve-like form and is fitted on a housing cover (29) and/or the housing cover (29) in certain portions is in the form of a pillar-like and/or sleeve-like receiving element (23, 24).

9. Production process for an electronics module (20), in which a printed circuit board (10) having at least one through-opening (11) is fitted on at least one receiving element (23, 24) in a housing lower part (21) with fastening means and then a housing upper part (22) is fastened, **characterized in that** the following steps are carried out:
a) providing the housing lower part (21),
b) placing the printed circuit board (10) onto the at least one receiving element (23) of the housing lower part (21),
c) passing the at least one fastening means through the through-opening (11) and pressing it into the at least one receiving element (23), the electronics module (20) being designed with the fastening means in the form of a locking bolt (1) according to one of Claims 1 to 8, and
d) pressing the head end (6) of the second bolt portion (3) into at least one receiving element (24) of the housing upper part (22).

10. Production process according to Claim 9, **characterized in that**, before step d), a sealing or adhesive material (12) is applied to and/or placed onto a housing edge (21.1, 22.1) at least in certain portions.

11. Production process according to either of Claims 9 and 10, **characterized in that** at least one respective cutting and/or friction ring (5.1, 6.1, 9, 9.1, 14, 15) is form-fittingly and/or force-fittingly pressed in each receiving element (23, 24) of the housing upper and lower part.

## Revendications

1. Module électronique (20), comprenant une partie de boîtier inférieure (21), une carte de circuit imprimé (10), un moyen de fixation et une partie de boîtier supérieure (22), la carte de circuit imprimé (10) comportant au moins une ouverture de passage (11) destinée à la fixation au moyen de fixation qui est inséré, et fixé, par une première extrémité à travers l'ouverture de passage (11) dans un élément de réception aligné (23) de la partie de boîtier inférieure (21) par une liaison en force et/ou à complémentarité de formes, un élément de réception (24) disposé en alignement avec l'élément de réception (23) de la partie de boîtier inférieure (21) étant prévu sur la partie de boîtier supérieure (22), l'autre extrémité du moyen de fixation étant insérée et fixée par une liaison en force et/ou à complémentarité de formes dans au moins un élément de réception (23) de la partie de boîtier supérieure (22), le moyen de fixation étant réalisé sous la forme d'un boulon d'encliquetage (1) qui comprend au moins une portion d'appui en saillie (4) et une première portion de boulon (2) pourvue d'une extrémité de tête (6) et d'une portion de col de liaison (8), au moins une couronne de coupe et/ou de friction (6.1, 9.1) en une ou plusieurs parties étant disposée dans la zone de l'extrémité de tête (6) et/ou de la portion de col (8), une deuxième portion de boulon (3) étant disposée du coté arrière de la portion d'appui en saillie (4), la deuxième portion de boulon (3) comportant une extrémité de tête (5) et une portion de col de liaison (7), et au moins une couronne de coupe et/ou de friction (5.1) en une ou plusieurs parties étant disposée dans la zone de l'extrémité de tête (5) et/ou de la portion de col (7), et **caractérisé en ce que** la carte de circuit imprimé (10) étant centrée et pressée en permanence sur les éléments de réception (23) de la partie de boîtier inférieure (21) par la portion d'appui en saillie (4) du boulon d'encliquetage (1) .

2. Module électronique (20) selon la revendication 1, **caractérisé en ce que** la deuxième portion de boulon (3) du boulon d'encliquetage (1) est plus courte que la première portion de boulon (2), notamment la longueur de la deuxième portion de boulon (3) représente de 0,25 fois à 0,75 fois la première portion de boulon (2).

3. Module électronique (20) selon l'une des revendications 1 ou 2, **caractérisé en ce que** le boulon d'encliquetage (1) est réalisé sur au moins une des extrémités de tête (5, 6) sous la forme d'un élargissement de type tête de champignon et/ou capuchon dont le bord inférieur circonférentiel est conçu comme une couronne de coupe (5.1, 6.1).

4. Module électronique (20) selon l'une des revendications précédentes, **caractérisé en ce qu'**une couronne de coupe et/ou de friction (9, 14, 15) en une ou plusieurs parties est disposée sur au moins une portion de col (7, 8) du boulon d'encliquetage (1).

5. Module électronique (20) selon l'une des revendications précédentes, **caractérisé en ce que** le boulon d'encliquetage (1) est réalisé à partir d'un métal, notamment d'un métal inoxydable ou d'une matière synthétique, notamment d'un PVC, PP, PET ou POM.

6. Module électronique (20) selon l'une des revendications précédentes, **caractérisé en ce que** la partie de boîtier supérieure (22) et la partie de boîtier inférieure (21) comporte un bord (21.1, 22.1), les bords (21.1, 22.1) étant collés ensemble au moins par portions, en particulier collés ensemble sur toute la longueur.

7. Module électronique (20) selon l'une des revendications précédentes, **caractérisé en ce qu'**un élément de support (27, 28) en forme de nervure est disposé au moins entre une paroi de boîtier (25, 26) et l'un des éléments de réception (23, 24).

8. Module électronique (20) selon l'une des revendications précédentes, **caractérisé en ce qu'**au moins un élément de réception (23, 24) est conçu comme une colonne et/ou un manchon et est fixé sur un couvercle de boîtier (29) et/ou le couvercle de boîtier (29) est conçu par portions comme un élément de réception (23, 24) en forme de colonne et/ou de manchon.

9. Procédé de fabrication d'un module électronique (20), procédé dans lequel une carte de circuit imprimé (10) comportant au moins une ouverture de passage (11) est fixée à au moins un élément de réception (23, 24) dans une partie de boîtier inférieure (21) à l'aide de moyens de fixation, puis une partie de boîtier supérieure (22) est fixée, **caractérisé en ce que** les étapes suivantes sont réalisées :
a) fournir la partie de boîtier inférieure (21),
b) placer la carte de circuit imprimé (10) en appui sur l'au moins un élément de réception (23) de la partie de boîtier inférieure (21),
c) faire passer l'au moins un moyen de fixation à travers l'ouverture de passage (11) et l'enfoncer dans l'au moins un élément de réception (23), le module électronique (20) pourvu du moyen de fixation étant conçu comme un boulon d'encliquetage (1) selon l'une des revendications 1 à 8 et
d) enfoncer l'extrémité de tête (6) de la deuxième portion de boulon (3) dans au moins un élément de réception (24) de la partie de boîtier supérieure (22).

10. Procédé de fabrication selon la revendication 9, **caractérisé en ce que**, avant l'étape d), une matière adhésive ou d'étanchéité (12) est appliquée et/ou posée au moins par portions sur un bord de boîtier (21.1, 22.1) .

11. Procédé de fabrication selon l'une des revendications 9 ou 10, **caractérisé en ce qu'**au moins une couronne de coupe et/ou de friction (5.1, 6.1, 9, 9.1, 14, 15) est enfoncée dans chaque élément de réception (23, 24) des parties de boîtier supérieure et inférieure par une liaison en force et/ou à complémentarité de formes.
